# EUROPEAN PATENT APPLICATION

(11) **EP 2 790 473 A1**
(43) Date of publication of application: **15.10.2014**
(21) Application number: 13162869.5
(22) Date of filing: 09.04.2013
(51) Int. Cl.: H05K 1/02, H05K 3/12

(54) **Optimizing parameters for printing solder paste onto a PCB**

(71) Applicant: ASM Assembly Systems GmbH & Co. KG, 81379 München (DE)
(72) Inventor: Greer, Mathew, Glenrothes, Fife KY75DZ (GB); Gray, Robert, Buford, GA Georgia 30518 (US)
(74) Representative: Dilg, Haeusler, Schindelmann Patentanwaltsgesellschaft mbH

(57) **Abstract**

In this document there is described a method for generating optimized parameters for printing a printed circuit board (190). The described method comprises the steps of (a) printing a plurality on printed circuit boards with a solder paste printing machine (110), wherein solder paste is applied in a controlled manner to each one of the plurality of printed circuit boards (190), (b) inspecting the resultant solder paste applied to the plurality of printed circuit boards (190) with a solder paste inspection machine (120), (c) analyzing inspection data obtained from inspecting the solder paste applied to the plurality of printed circuit boards (190), and (d) generating an optimized set of printing parameters for printing further printed circuit boards (190) based on the analyzed inspection data. Further, there are described a control device(130), a system (100) and a computer program, which are all configured for controlling and/or carrying the method for generating optimized parameters for a printed circuit board.

## Description

### Field of invention

The present invention relates to the field of manufacturing printed circuit boards by applying an appropriate amount of solder paste at predefined locations within the printed circuit boards. These locations are connection pads which are used to contact terminals of electronic components to a circuit path pattern being provided on the respective printed circuit board. In particular the present invention relates to a method for optimizing a printing process of a printed circuit board. Further, the present invention relates to a control device, to a system and to a computer program, which are all configured for controlling and/or carrying the method for optimizing a printing process of a printed circuit board.

### Art Background

The automatic production of electronic assemblies typically starts with a printed circuit board (PCB) printing process, wherein an appropriate amount of solder paste is applied at predefined locations within the PCB. These locations represent connection pads for terminals of electronic components which are mounted to the PCB by means of a placement process, e.g. a so called pick and place process carried out by an automatic placement machine. Later, the electronic components are secured by means of a soldering procedure which can be carried out e.g. within a reflow oven.

In order to produce electronic assemblies with a high quality and in order to avoid the formation of defective electric contacts between the electronic components and the PCB the printing process has to be carried out very carefully. This means that it has to be ensured that each connection pad receives an appropriate amount of solder paste wherein over the area of the connection pad the solder paste is also distributed in an appropriate manner.

The quality of a PCB printing process strongly depends on a setting of printing parameters and wiping parameters.

In this respect printing is the process during which solder paste is applied to the PCB through apertures formed within a so called stencil. Thereby, a squeegee blade is moved over a stencil being located on top of the PCB in such a manner that viscous solder paste is transferred into the apertures of the stencil. Afterwards, the PCB is removed from the stencil and depending on adhesion forces between the solder paste and the PCB the solder paste remains adhered at the PCB. Printing parameters are e.g. the speed of the squeegee blade, the length or the stroke of the movement of the squeegee blade over the stencil, the speed at which the PCB is removed from the stencil, etc..

In this respect wiping is the process during which the underside of the stencil, after the PCB has been removed from the stencil, is cleaned. Thereby, residues of solder paste which remain adhered to the underside of the stencil are removed. The wiping is accomplished by means of lint free paper hereafter referred to as "Paper" which is moved along the underside of the stencil. Wiping parameters are e.g. the speed at which the paper is moved along the underside of the stencil, the wipe sequence i.e. the number of strokes which clean the underside of the stencil, a possible amount of solvent which is added to the paper, etc..

Optimizing printing and cleaning parameters manually for a particular PCB is very labor intensive even for a well experienced user. Thereby, it might be necessary to set up and evaluate proper printing experiments on a case by case basis.

There may be a need for automatically setting the printing parameters and the wiping parameters in such a manner that a high quality of a PCB printing process can be achieved.

### Summary of the Invention

This need may be met by the subject matter according to the independent claims. Advantageous embodiments of the present invention are described by the dependent claims.

According to a first aspect of the invention there is provided a method for generating optimized parameters for printing a printed circuit board. The provided method comprises the steps of (a) printing a plurality on printed circuit boards with a solder paste printing machine, wherein solder paste is applied in a controlled manner to each one of the plurality of printed circuit boards with a different set of printing parameters individually associated with each printed circuit board, (b) inspecting the resultant solder paste applied to the plurality of printed circuit boards with a solder paste inspection (SPI) machine, (c) analyzing inspection data obtained from inspecting the solder paste applied to the plurality of printed circuit boards, and (d) generating an optimized set of printing parameters for printing further printed circuit boards based on the analyzed inspection data.

The described method is based on the idea that by automatically analyzing inspection data obtained from a plurality of produced printed circuit boards, wherein each printed circuit board (PCB) has been produced with different printing parameters, the printing parameters for a production of further PCBs having the same design or layout can be automatically optimized. Thereby, the analysis of the inspection data and an optimization (of the parameter set) of printing parameters can be carried out in a control device with an appropriate software, which is connected both to a solder paste printing machine which executes the printing of the plurality of printed circuit boards and to a solder paste inspection machine which inspects the solder paste which has been applied to the plurality of printed circuit boards.

Descriptive speaking, the described method for generating optimized parameters for printing a printed circuit board automatically steps through a set of the printing experiments, wherein with each experiment there is applied solder paste to of the plurality of printed circuit boards. Thereby, recipes for the printing experiments can be automatically created or changed on the fly in the solder paste printing machine as the set of printing experiments is ran automatically. Due to the automated execution the plurality of printing experiments can be accomplished much faster as compared to corresponding printing experiments which in accordance with the state of the art must be triggered manually by a user.

The described method may use an automatic communication between the machines for printing and inspecting the PCBs on the one side and the control device carrying out (a) the analysis of the inspection data, and (b) the generation of the optimized set of printing parameters. Thereby, a two-way communication between (a) the solder paste printing machine and (b) the solder paste inspection machine ensures that all data being necessary for carrying out the described method can be transferred to the proper machine. Specifically, the solder paste printing machine will inform the solder paste inspection machine which one of the plurality of PCBs is transferred to the solder paste inspection machine for inspection. Further, the solder paste inspection machine provides to the control device the inspection results which are analyzed and/or evaluated by the control device. The optimized set of printing parameters which results from this analysis is then transferred to the solder paste printing machine which will use these optimized parameters for printing further PCBs.

In other words, by delivering a proper two-way communication between the solder paste printing machine and the SPI machine, if applicable via the control device, it can be ensured that data characterizing the status of each machine can be communicated correctly and also in more detail. This allows for an automation of the inspection data analysis.

Using such an automated communication between the solder paste printing machine, the solder paste inspection machine, and the control device may allow for an optimization of the whole printing process within a production line for producing electronic assemblies. A user (e.g. an operator of the production line) has the ability to optimize the whole production process and to minimize the engineering effort when a new electronic assembly product is introduced or when at the request of the user the performance of the production line should be improved by optimizing the PCB printing procedure.

It is mentioned that if the printing parameters are intended to be refined or optimized within an existing process window the described method can be carried out without any longer interruption of a production process of electronic assemblies. This means that within a production of electronic assemblies the printing process can be continuously optimized. Of course, the described method can also be carried out in a fast and easy manner when a new electronic assembly product is introduced respectively is supposed to be produced by a production line.

In the case where the SPI of a PCB fails or in case the printing results are not acceptable, the respective PCB can be removed in a known manner from the electronic assembly production line.

According to an embodiment of the invention the method further comprises the steps of (a) forwarding the optimized parameter set of printing parameters to the solder paste printing machine, (b) printing at least one further PCB with the solder paste printing machine, (c) inspecting the resultant solder paste applied to the at least one further PCB with the solder paste inspection machine, (d) analyzing inspection data obtained from inspecting the solder paste applied to the at least one further PCB, and (e) if the analyzed inspection data fulfill a predefined printing quality criterion, thereafter starting or continuing a production process , wherein solder paste is applied to PCBs by the solder paste printing machine using the optimized set of printing parameters.

Descriptive speaking, in accordance with the described method the results of the solder paste inspection are fed to the control device where a software package will analyze these results and will deliver an optimized set of printing parameters to the solder paste printing machine. The software of the control device will then control a printing process with the optimized set of printing parameters in order to realize a so called printer confirmation run. If this confirmation run yields acceptable printing results a production of electronic assemblies can be continued or a production of a new type of electronic assemblies can be started.

Preferably, not only one PCB but a set of several PCBs of one and the same type will be printed during such a confirmation run with the optimized printer parameters which have been passed to the solder paste printing machine. The SPI machine will then inspect a statistically valid number of PCBs with regard to the respective solder paste which has been applied and the control device analyses this statistically valid number of PCBs. By applying a statistical evaluation the control device can then confirm in a reliable manner whether the set of printing parameters used for the confirmation run is indeed at least very close to an optimized set of printing parameters for this particular design of PCB.

According to a further embodiment of the invention, if the analyzed inspection data do not comply with the predefined printing quality criterion, the method further comprises (a) printing an additional plurality of PCBs with the solder paste printing machine, wherein solder paste is applied in a controlled manner to each one of the additional plurality of PCBs with a different set of printing parameters individually associated with each additional PCB, (b) inspecting the resultant solder paste applied to the additional plurality of PCBs with the solder paste inspection machine, (c) analyzing additional inspection data obtained from inspecting the solder paste applied to the additional plurality PCBs, and (d) further generating another optimized set of printing parameters for printing further PCBs based on the analyzed additional inspection data.

Descriptive speaking, if, after having optimized the set of printing parameters by means of a (first) set of printing experiments, the resulting printing process is not optimized in a sufficient manner, the optimizing procedure described above is carried out again with an additional plurality of PCBs. Of course, the step of generating an optimized set of printing parameters respectively the corresponding optimizing procedure can be repeated so often until a sufficient quality of the printing process has been achieved.

According to a further embodiment of the invention the method further comprises the steps of (a) associating each individual printed circuit board of the plurality of PCBs with a corresponding set of printing parameters, and (b) assigning each individual printed circuit board to the analyzed inspection data which have been obtained from inspecting such individual PCB. Thereby, it can be ensured that there is a preferably unambiguous assignment between each individual PCB and (i) the corresponding set of printing parameters which have been applied when printing the PCB and (ii) the corresponding analyzed inspection data which have been obtained for the particular PCB when analyzing the obtained inspection data. In this way the results of analyzing the inspection data are in an unambiguous manner assigned to the set of printing parameters which have been applied when printing the respective PCB.

In this respect it is mentioned that in order to guarantee a fail-safe assignment between (i) the results of analyzing the inspection data and (ii) the corresponding set of printing parameters each PCB can be provided with a unique identification mark. This identification mark may be a bar code, a 2-d matrix code and/or a radio frequency identification tag.

According to a further embodiment of the invention analyzing inspection data obtained from inspecting the PCBs comprises performing a statistical evaluation of the inspection data which have been obtained by inspecting the plurality of printed circuit boards.

Using a statistical evaluation may provide the advantage that the analysis of the inspection data will be very reliable.

According to a further embodiment of the invention the performed statistical evaluation is based on a Taguchi analysis.

Using the known Taguchi analysis for performing the statistical evaluation of the inspection data may provide the advantage (in particular compared to other statistical evaluations) that a reliable statistical result can be obtained not only when the value of one printing parameter is varied but also when the values of two printing parameters are varied between two subsequent PCB printing procedures at the same time. In particular when the selection of values for a plurality of printing parameters in combination is responsible for a good or a bad printing result, the Taguchi analysis allows for obtaining the optimized set of printing parameters with a reduced number of printing procedures. Therefore, the optimized (values of the) set of printing parameters can be gathered very quickly. This reduces the amount of time which is necessary to carry out the described method for optimizing a printing process. Therefore, in order to increase the performance of a whole production line the described method may be carried out from time to time without significantly increasing the down time of the whole electronic assembly production line.

According to a further embodiment of the invention the method further comprises the step of selecting a subarea for each PCB from the plurality of PCBs. Thereby, the analysis of the inspection data is carried out exclusively in relation to inspection data obtained from the selected subarea of each PCB. This may provide the advantage that the described method and in particular the analysis of the inspection data can be carried out very quickly, because the analysis is performed not for the whole surface area of the respective PCB but only for the selected subarea which represents only a part of the whole surface area of the respective printed circuit board.

According to a further embodiment of the invention each selected subarea defines a printing region of a total surface area of the respective PCB, which printing region is with respect to the quality of the printing process more sensitive against a variation of the set of printing parameters as compared to other printing regions of the total surface area of the respective PCB.

Specifically, within the selected subarea the printing process is less robust against variations of the value of at least one printing parameter. Depending on the design of a PCB even a minor experienced user will be able to predetermine the selected subarea which defines a printing region wherein the quality of the printing process is more critical than in other printing regions.

The selected subarea may be defined by the number or the density of printing defects which can be expected when non optimal printing parameters are used for the printing process. In particular, within the selected subarea the number or the density of expected printing defects may be larger than a predefined threshold. In this respect a printing defect may be given e.g. if the amount or the volume of applied solder paste does not correspond sufficiently to a predefined amount or volume of solder paste which is considered as to be appropriate for the particular connection pad.

The selected subarea may further be defined by the area ratios of apertures within a stencil. The area ratio of an aperture within a stencil is defined in a known manner by the ratio between (a) the opening area of the aperture and (b) the surface of the inner wall of the stencil, which defines the aperture. In this respect it is mentioned that in a printing process an aperture within a stencil being located directly onto a printed circuit board is first used to accommodate a certain amount or volume of solder paste. When, after the aperture has been filled with solder paste, the PCB is removed from the stencil, the solder paste is supposed to adhere to the respective connection pad of the PCB. At least the solder paste should adhere better to the PCB as to the stencil. In this respect it is clear that a transfer of solder paste by means of small stencil aperture and in particular by a stencil aperture which has a small area ratio is more error-prone as compared to a transfer of solder paste by means of large stencil aperture and in particular by a stencil aperture which has a large area ratio.

It is pointed out that the above given conditions for selecting a proper subarea are only exemplary. A skilled user will know and is able to use other conditions for selecting a subarea wherein the quality of the solder paste transfer is particularly sensitive against a variation of the set of printing parameters.

According to a further embodiment of the invention each PCB to which solder paste is applied is individually associated with a different set of wiping parameters for cleaning a stencil prior to printing the PCB by transferring solder paste through apertures formed within the stencil. The method according to this further embodiment further comprises the step of generating a set of optimized wiping parameters being used for cleaning the stencil prior to printing further PCBs based on the analyzed inspection data. This may provide the advantage that not only the printing process itself but also the process of cleaning the underside of the stencil by wiping, which underside faces the PCB being supposed to be printed, can be optimized with the method described in this document. In this respect it is mentioned that in the language used in this document the process of printing comprises only the transfer of solder paste through apertures formed within the stencil and does not include the cleaning process by wiping the underside of the stencil in a known manner with a paper.

The described set of wiping parameters may be include for instance a wiping speed which is the relative speed between the stencil and the paper which is used for cleaning the underside of the stencil. A further wiping parameter may be for instance the number of wiping strokes which are carried out for cleaning the underside of the stencil. In this respect the number of wiping strokes may be one when the paper is moved only one time in one direction along the underside of the stencil. Correspondingly, the number of wiping strokes may be two if the paper is moved back and forth in order to clean the underside of the stencil. A further wiping parameter may be for instance the wetness of the paper in case the paper has absorbed a solvent agent which in a known manner increases the cleaning capability of the paper. A further wiping parameter may be the wiping pressure which is the pressure with which the paper is pressed against the underside of the stencil during a wiping stroke. It is mentioned that the described examples for wiping parameters is not exclusive. A person skilled in the art will know further examples of wiping parameters which can be optimized with the described method.

Also for the wiping effectiveness optimization experimentation the effectiveness can be measured by taking results from the SPI for particular areas of the PCB, but also the SPP can be instructed to use a fiducial camera to inspect certain areas of the stencil for solder paste in the apertures and solder paste and flux at the bottom of the stencil. The SPP in this case will simply take the images with the fiducial camera after each particular experiment run with certain parameters. The optimization software and control device will perform the necessary vision analysis to convert the image into definite measurements to be used to gauge the effectiveness of the cleaning in isolation or/in conjunction with the SPI results.

According to a further embodiment of the invention generating the optimized set of wiping parameters for cleaning the stencil prior to printing further printed circuit boards is further based on data which have been obtained with a camera that is associated with the solder paste printing machine and which have been analyzed with a processing unit that is associated with the solder paste printing machine.

The described camera that is associated with the solder paste printing machine may be in particular a so called printer fiducial camera, which apart from identifying the positions of fiducials at the stencil and/or at the printed circuit board can look at stencil apertures and at the bottom of a stencil being used for printing the plurality of PCBs in the solder paste printing machine. This provides much more data in regard to a cleaning procedure for the stencil such that the set of wiping parameters that is used for cleaning the stencil prior to printing further PCBs can be optimized in a very effective and reliable manner. The printer fiducial camera and/or the processing unit that is associated with the solder paste printing machine can be instructed by a control device which is connected both with the solder paste printing machine and with the solder paste inspection machine in order to control the above specified method which can be used for optimizing a printing process of a printed circuit board.

According to a further aspect of the invention there is provided a control device for generating optimized parameters for printing a PCB. The provided control device comprises (a) an input interface for receiving inspection data obtained from inspecting a plurality PCBs by a solder paste inspection machine, wherein the plurality of PCBs has been printed with a solder paste printing machine, wherein each one of the plurality of PCBs is individually associated with a different set of printing parameters for printing a printed circuit board, (b) a processing unit for analyzing the received inspection data and for generating the optimized set of printing parameters for printing further PCBs based on the analyzed received inspection data, and (c) an output interface for providing a control signal to the solder paste printing machine for printing at least one further PCB, wherein the control signal is representative of the optimized set of printing parameters.

The described control device is based on the idea that a solder paste printing machine can be triggered in order to automatically execute a plurality of printing procedures and if necessary image capture subroutines, wherein the printing parameters that are used for printing different PCBs of a plurality of PCBs is varied. After having received inspection data from a solder paste inspection machine, which has inspected the plurality of PCBs, the processing unit of the described control device is configured to analyze the inspection data received from the solder paste inspection machine. Further, the described control device is configured to generate the optimized set of printing parameters based on the analyzed inspection data. The output interface of the described control device can then forward the optimized set of printing parameters to the solder paste printing machine such that further PCBs will be printed with the optimized set of printing parameters.

As has already been mentioned above, before the optimized set of printing parameters is used for printing a larger number of PCBs which are supposed to be used for electronic assemblies being produced by an electronic assembly production line, a so called confirmation run can be executed. In such a confirmation run at least one PCB being printed with the optimized set of printing parameters is again inspected in order to ensure that the optimized set of printing parameters will yield in deed PCBs of a high quality at least for the electronic assembly which is supposed to be produced.

According to a further aspect of the invention there is provided a system for generating optimized parameters and for carrying out printing of a printed circuit board. The provided system comprises (a) a solder paste printing machine, (b) a solder paste inspecting machine, and (c) a control device as described above. The control device is connected both to the solder paste printing machine and to the solder paste inspecting machine in order to allow the control device to control the operation of the solder paste printing machine and to receive inspection data obtained from the solder paste inspecting machine.

According to a further aspect of the invention there is provided a computer program for generating optimized parameters of a printed circuit board. The computer program, when being executed by a data processor, is operative to control and/or to carry out the method as described above for generating optimized parameters.

As used herein, reference to a computer program is intended to be equivalent to a reference to a program element and/or to a computer readable medium containing instructions for controlling a computer system to coordinate the performance of the above described method.

The computer program may be implemented as computer readable instruction code in any suitable programming language, such as, for example, JAVA, C++, and may be stored on a computer-readable medium (removable disk, volatile or non-volatile memory, embedded memory/processor, etc.). The instruction code is operable to program a computer or any other programmable device to carry out the intended functions. The computer program may be available from a network, such as the World Wide Web, from which it may be downloaded.

The invention may be realized by means of a computer program respectively software. However, the invention may also be realized by means of one or more specific electronic circuits respectively hardware. Furthermore, the invention may also be realized in a hybrid form, i.e. in a combination of software modules and hardware modules.

It has to be noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless other notified, in addition to any combination of features belonging to one type of subject matter also any combination between features relating to different subject matters, in particular between features of the method type claims and features of the apparatus type claims is considered as to be disclosed with this document.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawing

- Figure 1: shows a system for optimizing and for carrying out a printing process of a printed circuit board.
- Figure 2: shows a flow diagram illustrating a process of optimizing the values of printing parameters for printing a printed circuit board.
- Figure 3: shows a flow diagram illustrating a process of optimizing the values of wiping parameters for cleaning a stencil being used for printing a printed circuit board.

### Detailed Description

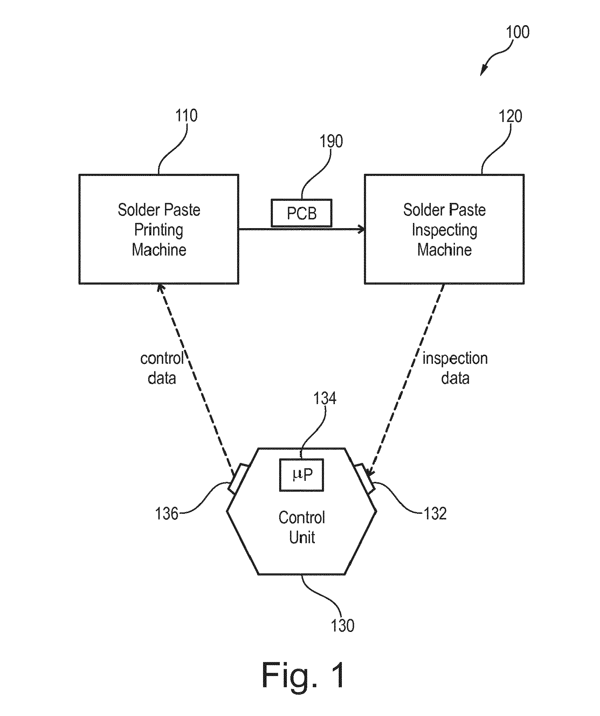

Figure 1 shows a system 100 for generating optimized printing parameters and for carrying out a printing of a printed circuit board (PCB) 190. The system 100 comprises a solder paste printing (SPP) machine 110, a solder paste inspecting (SPI) machine 120, and a control device 130. As can be seen from Figure 1, the control device 130 is connected both to the SPP machine 110 and to the SPI machine 120. In the following it will be described how in accordance with a preferred embodiment of the invention a method for optimizing a printing process for of a PCB can be carried out.

In the beginning a set of printing experiments is prepared by the control device 130. Thereby, each printing experiment is individually associated with a different set of printing parameters for printing one PCB 190 out of a plurality of PCBs. The corresponding data representing a plurality of sets of printing parameters are forwarded from the control device 130 via an output interface 136 of the control device 130 to the SPP machine 110. Thereby, the number of sets being included in the plurality of sets of printing parameters corresponds to the number of prepared printing experiments.

Upon receipt of these data the SPP machine 110 automatically executes sequentially all printing experiments which are included in the set of printing experiments. After printing a PCB 190 the PCB 190 is transferred by a non depicted conveyor to the SPI machine 120. In the SPI machine 120 the quality, e.g. the volume and the spatial distribution of solder paste which has been applied to connection pads of the PCB 190, is measured. The corresponding process is called SPI. The corresponding data are called inspection data. After having performed the SPI the inspection data originating from inspecting each PCB 190 are transferred to the control device 130 via an output interface 136 of the control device 130.

Within a processing unit 134 of the control device 130 the set of inspection data obtained from inspecting the solder paste applied to the plurality of PCBs 190 is analyzed in such a manner that for printing further PCBs an optimized set of printing parameters is generated. This optimized set of printing parameters is transferred to the SPP machine 110, where for printing further PCBs the optimized set of printing parameters is used.

It is pointed out that when performing this method for generating optimized printing parameters for printing a PCB special care has to be taken that there is maintained a correct assignment between (a) each set of printing parameters, (b) the corresponding PCB which has been printed or produced with this set of printing parameters and (c) the corresponding inspection data which have been obtained by the SPI machine 120 when inspecting the solder paste applied to the corresponding PCB. Thereby it might be helpful if each PCB 190 is provided with a unique identification mark. This identification mark may be e.g. a bar code, a 2-d matrix code and/or a radio frequency identification (RFID) tag. This unique identification mark can be recognized both by the SPP machine 110 and the SPI machine 120.

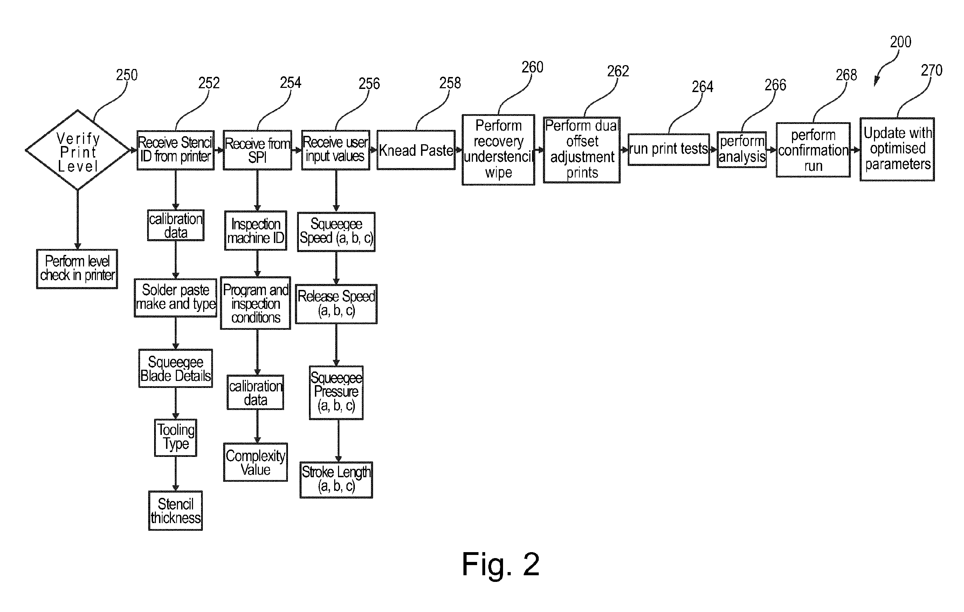

Figure 2 shows flow diagram 200 illustrating a process of optimizing the values of printing parameters for printing a PCB. In a first step 250 the print level is verified. In this respect the print level is the elevation of the underside of the stencil within the SPP machine. As can be seen from Figure 2, the step 250 comprises a so called level check being performed in the SPP machine.

In a next step 252 the control device receives a stencil ID from the SPP machine. As can be seen from Figure 2, in addition to the stencil ID calibration data of the SPP machine, the solder paste make and type (i.e. the name of the solder paste product and the type of the solder paste product), squeegee blade details (e.g. the type and/or the angle of the blade being used for pressing the solder paste into apertures of the stencil), tooling type (i.e. the configuration of the support mechanism supporting the PCB during the printing process), and the thickness of the used stencil are received by the control device.

In a next step 254 the control device receives from the SPI machine the ID of the SPI machine, information about the inspection program and the inspection condition (e.g. threshold values of inspection parameters which are used for deciding whether a solder paste transfer to the PCB has to be considered as to be defective or as to be correct), calibration data and at least one complexity value (e.g. the area ratios of the apertures being used to transfer solder paste onto connection pads of the PCB).

In a next step 256 the control device receives from a user or from an operator some input values for printing parameters. These values can be taken e.g. from a previous printing process which has been considered as to be a printing process of a sufficient quality. According to the embodiment described here the input values are the squeegee speed (i.e. the speed with which the blade is moved along the upper surface of the stencil), the release speed (i.e. the speed with which, after all relevant apertures of the stencil are filled with solder paste, the PCB is removed from the stencil in a direction parallel to a normal vector of the lower surface of the stencil), the squeegee pressure (i.e. the pressure at which the squeegee is applied to the stencil), and the stroke length (i.e. the length of the stroke of the blade being moved along the upper surface of the stencil).

In a next step 258 the solder paste is kneaded in order to ensure at all times during the initiation of an experimental run the same working conditions of the solder paste.

In a next step 260 there is performed a recovery of the under stencil wipe. This means that solder paste remaining from a previous printing process at the underside of the stencil is removed from (the underside of) the stencil.

In a next step 262 there are performed dual offset adjustment prints. This is done in preparation of the successive print tests respectively the successive set of printing experiments. With the dual offset adjustment prints it can be ensured that in the successive print tests there is adjusted a correct spatial alignment between the stencil and the PCBs which are supposed to be provided with solder paste. This step is to ensure that these parameters have been properly set prior to the experimental run.

In a next step 264 there is executed a predefined set of printing experiments by the SPP machine, wherein each printing experiment is individually associated with a different set of printing parameters. Thereby, solder paste is applied in a controlled manner to each one of the set of PCBs. Further, in this step 264 there is also performed by the SPI machine an inspection of the plurality of printed circuit boards resulting from executing the plurality of printing experiments.

In a next step 266 there is performed an analysis of inspection data which have been obtained by the inspection carried out by the SPI machine. Thereby, an optimized set of printing parameters for printing a PCB is determined based on the analyzed inspection data.

In a next step 268 there is performed a confirmation run. In this confirmation run it is determined whether with the optimized set of printing parameters really there can be achieved a high quality solder paste transfer onto the PCBs.

In case the confirmation run was successful, in a next step 270 the SPP machine will be updated by the control device with the optimized set of printing parameters. Now the SPP machine is ready for a high quality printing of further PCBs.

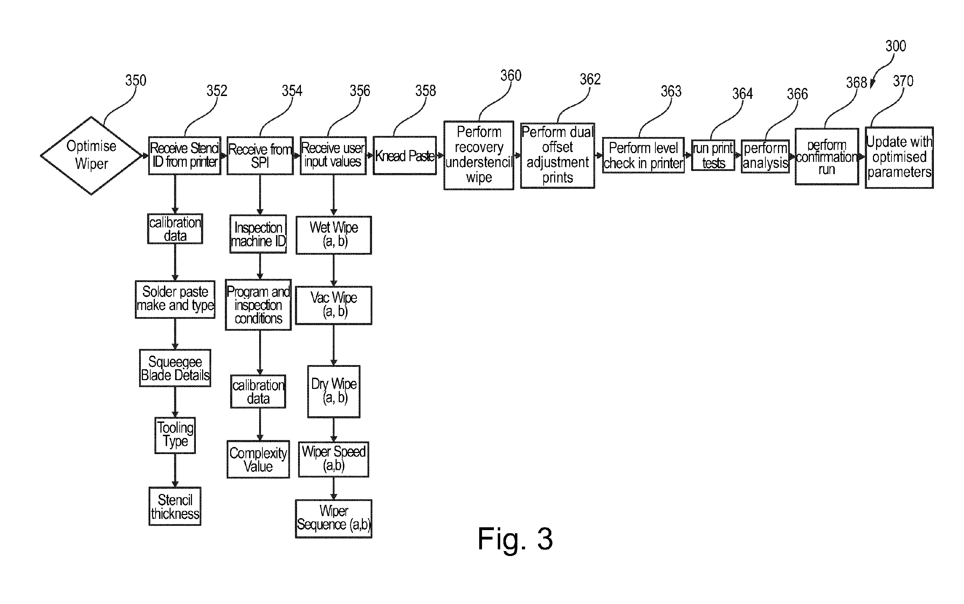

Figure 3 shows a flow diagram 300 illustrating a process of optimizing the values of wiping parameters for cleaning a stencil being used for printing a PCB. The process starts with a step 350.

A next step 352 is the same as the step 252 elucidated above with reference to Figure 2. For the sake of conciseness the step 352 will not be explained again. Instead, reference is made to the description given above.

A next step 354 is the same as the step 254 elucidated above with reference to Figure 2. For the sake of conciseness also the step 354 will not be explained again. Again, reference is made to the description given above.

In a next step 356 the control device receives from a user or from an operator some input values for wiping parameters. These values can be taken e.g. from a previous wiping process which has been considered as to be a wiping process of a sufficient quality. According to the embodiment described here the input values for the wiping parameters are the wetness of a wipe (i.e. the amount of solving agent which has been absorbed by the paper being used for wiping the underside of the stencil), the vacuum being associated with a wiping stroke, the use of a dry wipe (i.e. the paper is not to have solvent added to the paper but rather the paper us to be used in its original dry condition), the wiper speed (i.e. the speed with which the wiping paper is moved relative to the stencil), and the wiper sequence (i.e. the number of strokes the wiping paper performs for cleaning the underside of the stencil).

The next steps 358, 360 and 362 are the same as the steps 258, 260 and 262, respectively, which have already been elucidated above with reference to Figure 2. For the sake of conciseness also these steps 358, 360 and 362 will not be explained again. Again, reference is made to the description given above.

In a next step 363 there is performed a level check in the SPP machine. Thereby, it is checked whether the height level of the underside of the stencil corresponds to the height level of the upper side of the PCB.

In a next step 364 there is executed a predefined set of printing experiments by the SPP machine, wherein each printing experiment is individually associated with a different set of wiping parameters being applied for cleaning the underside of the stencil before the respective printing procedure is executed, wherein solder paste is applied in a controlled manner to each one of the set of PCBs. Further, in this step 364 there is also performed by the SPI machine an inspection of the plurality of PCBs resulting from the executed printing experiments.

In a next step 368 there is performed an analysis of inspection data which have been obtained by the inspection which has been carried out by the SPI machine. Thereby, an optimized set of wiping parameters for cleaning the underside of a stencil being later used for printing a PCB is determined based on the analyzed inspection data.

The next step 368 is the same as the step 268 which has been elucidated above with reference to Figure 2. For the sake of conciseness this step 368 will not be explained again. Again, reference is made to the description given above.

In case the confirmation run was successful, in a next step 370 the SPP machine will be updated by the control device with the optimized set of wiping parameters. Now the SPP machine is ready for a high quality printing of further PCBs.

The method for optimizing a printing process of a printed circuit board, which method is described in this document, may provide in particular the following advantages:

Using both the SPP and the SPI machines and the collected inspection data an optimal set of printing parameters and/or an optimal set of wiping parameters for optimised programs can be generated with little effort on behalf of a user or operator who can save time and resources.

It can be ensured that optimized programs can be delivered at the push of a button wherein results are automatically delivered to the user without having to perform an offline analysis. All the work is performed at the machines and in the control device, which is programmed with an appropriate software. Optimization of the inspection parameters can also be achieved by running a predefined number of PCBs. Using a statistical analysis of the SPI machine will also allow an application of the control limits determined by the optimized printing, wiping and/or inspecting process.

It should be noted that the term "comprising" does not exclude other elements or steps and the use of articles "a" or "an" does not exclude a plurality. Also elements described in association with different embodiments may be combined. It should also be noted that reference signs in the claims should not be construed as limiting the scope of the claims.

### List of reference signs:

| | |
|---|---|
| 100 | System for optimizing and for carrying out a printing process of a printed circuit board |
| 110 | Solder paste printing machine |
| 120 | Solder paste inspecting machine |
| 130 | Control device |
| 132 | Input interface |
| 134 | Processing unit |
| 136 | Output interface |
| 190 | Printed circuit board |
| | |
| 200 | Flow diagram illustrating the processes of printing and inspecting a printed circuit board |
| 250-270 | Process steps |
| | |
| 300 | Flow diagram illustrating the process of wiping the underside of a stencil being used for the solder paste printing process |
| 350-372 | Process steps |

## Claims

1. A method for generating optimized parameters for printing a printed circuit board (190), the method comprising the steps of:
printing a plurality of printed circuit boards (190) with a solder paste printing machine (110), wherein solder paste is applied in a controlled manner to each one of the plurality of printed circuit boards (190) with a different set of printing parameters individually associated with each printed circuit board (190),
inspecting the resultant solder paste applied to the plurality of printed circuit boards (190) with a solder paste inspection machine (120),
analyzing inspection data obtained from inspecting the solder paste applied to the plurality of printed circuit boards (190), and
generating an optimized set of printing parameters for printing further printed circuit boards (190) based on the analyzed inspection data.

2. The method as set forth in claim 1, further comprising the steps of:
forwarding the optimized set of printing parameters to the solder paste printing machine (110),
printing at least one further printed circuit board (190) with the solder paste printing machine (110),
inspecting the resultant solder paste applied to the at least one further printed circuit board (190) with the solder paste inspection machine (120),
analyzing inspection data obtained from inspecting the solder paste applied on the at least one further printed circuit board (190), and
if the analyzed inspection data fulfill a predefined printing quality criterion, thereafter starting or continuing a production process, wherein solder paste is applied to printed circuit boards (190) with the solder paste printing machine using the optimized set of printing parameters.

3. The method as set forth in claim 2, wherein
if the analyzed inspection data do not comply with the predefined printing quality criterion, the method further comprises
printing an additional plurality of printed circuit boards (190) with the solder paste printing machine (110), wherein solder paste is applied in a controlled manner to each one of the additional plurality of printed circuit boards (190) with a different set of printing parameters individually associated with each additional printed circuit board (190),
inspecting the resultant solder paste applied to the additional plurality of printed circuit boards (190) with the solder paste inspection machine (120),
analyzing additional inspection data obtained from inspecting the solder paste applied to the additional plurality of printed circuit boards (190), and
further generating another optimized set of printing parameters for printing further printed circuit boards (190) based on the analyzed additional inspection data.

4. The method as set forth in any one of the preceding claims, further comprising the steps of:
associating each individual printed circuit board (190) of the plurality of printed circuit boards (190) with a corresponding set of printing parameters, and
assigning each individual printed circuit board (190) to the analyzed inspection data which have been obtained from inspecting such individual printed circuit board (190).

5. The method as set forth in any one of the preceding claims, wherein analyzing inspection data obtained from inspecting the printed circuit boards (190) comprises
performing a statistical evaluation of the inspection data which have been obtained by inspecting the plurality of printed circuit boards (190).

6. The method as set forth in claim 5, wherein
the performed statistical evaluation is based on a Taguchi analysis.

7. The method as set forth in any one of the preceding claims, further comprising the step of:
selecting a subarea for each printed circuit board (190) from the plurality of printed circuit boards (190), wherein
analysis of the inspection data is carried out exclusively in relation to inspection data obtained from the selected subarea of each printed circuit board (190).

8. The method as set forth in claim 7, wherein
each selected subarea defines a printing region of a total surface area of the respective printed circuit board (190), which printing region is more sensitive against a variation of the set of printing parameters as compared to other printing regions of the respective printed circuit board (190).

9. The method as set forth in any one of the preceding claims, wherein
each printed circuit board (190) to which solder paste is applied is individually associated with a different set of wiping parameters for cleaning a stencil prior to printing the printed circuit board (190) by transferring solder paste through apertures formed within the stencil, the method further comprising the step of:
generating a set of optimized wiping parameters being used for cleaning the stencil prior to printing further printed circuit boards (190) based on the analyzed inspection data.

10. The method as set forth in claim 9, wherein
generating the optimized set of wiping parameters for cleaning the stencil prior to printing further printed circuit boards (190) is further based on data which have been obtained with a camera that is associated with the solder paste printing machine (110) and which have been analyzed with a processing unit that is associated with the solder paste printing machine (110).

11. A control device for generating optimized parameters for printing a printed circuit board, the control device (130) comprising
an input interface (132) for receiving inspection data obtained from inspecting a plurality of printed circuit boards (190) with a solder paste inspection machine (120), wherein the plurality of printed circuit boards (190) has been printed with a solder paste printing machine (110), wherein each one of the plurality of printed circuit boards (190) is individually associated with a different set of printing parameters for printing a printed circuit board (190),
a processing unit (134) for analyzing the received inspection data and for generating the optimized set of printing parameters for printing further printed circuit boards (190) based on the analyzed received inspection data, and
an output interface (136) for providing a control signal to the solder paste printing machine (110) for printing at least one further printed circuit board (190), wherein the control signal is representative of the optimized set of printing parameters.

12. A system for generating optimized parameters and for carrying out printing of a printed circuit board (190), the system (100) comprising
a solder paste printing machine (110),
a solder paste inspecting machine (120), and
a control device (130) as set forth in claim 11, wherein the control device (130) is connected both to the solder paste printing machine (110) and to the solder paste inspecting machine (120) in order to allow the control device (130) to control the operation of the solder paste printing machine (110) and
to receive inspection data obtained from the solder paste inspecting machine.

13. A computer program for optimizing a printing process of a printed circuit board (190), the computer program, when being executed by a data processor, is operative to control and/or to carry out the method as set forth in any one of the claims 1 to 9.

## Amended claims

### Amended claims in accordance with Rule 137(2) EPC.

**1.** A method for generating optimized parameters for printing a printed circuit board (190), the method comprising the steps of:
printing a plurality of printed circuit boards (190) with a solder paste printing machine (110), wherein solder paste is applied in a controlled manner to each one of the plurality of printed circuit boards (190) with a different set of printing parameters individually associated with each printed circuit board (190),
inspecting the resultant solder paste applied to the plurality of printed circuit boards (190) with a solder paste inspection machine (120),
analyzing inspection data obtained from inspecting the solder paste applied to the plurality of printed circuit boards (190), and
generating an optimized set of printing parameters for printing further printed circuit boards (190) based on the analyzed inspection data, **characterized in that**
each printed circuit board (190) to which solder paste is applied is individually associated with a different set of wiping parameters for cleaning a stencil prior to printing the printed circuit board (190) by transferring solder paste through apertures formed within the stencil, wherein the method further comprises the step of:
generating a set of optimized wiping parameters being used for cleaning the stencil prior to printing further printed circuit boards (190) based on the analyzed inspection data.

**2.** The method as set forth in claim 1, further comprising the steps of:
forwarding the optimized set of printing parameters to the solder paste printing machine (110),
printing at least one further printed circuit board (190) with the solder paste printing machine (110),
inspecting the resultant solder paste applied to the at least one further printed circuit board (190) with the solder paste inspection machine (120),
analyzing inspection data obtained from inspecting the solder paste applied on the at least one further printed circuit board (190), and
if the analyzed inspection data fulfill a predefined printing quality criterion, thereafter starting or continuing a production process, wherein solder paste is applied to printed circuit boards (190) with the solder paste printing machine using the optimized set of printing parameters.

**3.** The method as set forth in claim 2, wherein
if the analyzed inspection data do not comply with the predefined printing quality criterion, the method further comprises
printing an additional plurality of printed circuit boards (190) with the solder paste printing machine (110), wherein solder paste is applied in a controlled manner to each one of the additional plurality of printed circuit boards (190) with a different set of printing parameters individually associated with each additional printed circuit board (190),
inspecting the resultant solder paste applied to the additional plurality of printed circuit boards (190) with the solder paste inspection machine (120),
analyzing additional inspection data obtained from inspecting the solder paste applied to the additional plurality of printed circuit boards (190), and
further generating another optimized set of printing parameters for printing further printed circuit boards (190) based on the analyzed additional inspection data.

**4.** The method as set forth in any one of the preceding claims, further comprising the steps of:
associating each individual printed circuit board (190) of the plurality of printed circuit boards (190) with a corresponding set of printing parameters, and
assigning each individual printed circuit board (190) to the analyzed inspection data which have been obtained from inspecting such individual printed circuit board (190).

**5.** The method as set forth in any one of the preceding claims, wherein analyzing inspection data obtained from inspecting the printed circuit boards (190) comprises
performing a statistical evaluation of the inspection data which have been obtained by inspecting the plurality of printed circuit boards (190).

**6.** The method as set forth in claim 5, wherein
the performed statistical evaluation is based on a Taguchi analysis.

**7.** The method as set forth in any one of the preceding claims, further comprising the step of:
selecting a subarea for each printed circuit board (190) from the plurality of printed circuit boards (190), wherein
analysis of the inspection data is carried out exclusively in relation to inspection data obtained from the selected subarea of each printed circuit board (190).

**8.** The method as set forth in claim 7, wherein
each selected subarea defines a printing region of a total surface area of the respective printed circuit board (190), which printing region is more sensitive against a variation of the set of printing parameters as compared to other printing regions of the respective printed circuit board (190).

**9.** The method as set forth in any one of the preceding claims, wherein generating the optimized set of wiping parameters for cleaning the stencil prior to printing further printed circuit boards (190) is further based on data which have been obtained with a camera that is associated with the solder paste printing machine (110) and which have been analyzed with a processing unit that is associated with the solder paste printing machine (110).

**10.** A control device for generating optimized parameters for printing a printed circuit board, the control device (130) comprising
an input interface (132) for receiving inspection data obtained from inspecting a plurality of printed circuit boards (190) with a solder paste inspection machine (120), wherein the plurality of printed circuit boards (190) has been printed with a solder paste printing machine (110), wherein each one of the plurality of printed circuit boards (190) is individually associated
- with a different set of printing parameters for printing a printed circuit board (190) and
- with a different set of wiping parameters for cleaning a stencil prior to printing the printed circuit board (190) by transferring solder paste through apertures formed within the stencil,
a processing unit (134)
- for analyzing the received inspection data and for generating the optimized set of printing parameters for printing further printed circuit boards (190) based on the analyzed received inspection data and
- for generating a set of optimized wiping parameters being used for cleaning the stencil prior to printing further printed circuit boards (190) based on the analyzed received inspection data, and
an output interface (136)
- for providing a control signal to the solder paste printing machine (110) for printing at least one further printed circuit board (190), wherein the control signal is representative of the optimized set of printing parameters, and
- for providing a further control signal which is representative of the set of optimized wiping parameters.

**11.** A system for generating optimized parameters and for carrying out printing of a printed circuit board (190), the system (100) comprising
a solder paste printing machine (110),
a solder paste inspecting machine (120), and
a control device (130) as set forth in claim 10, wherein the control device (130) is connected both to the solder paste printing machine (110) and to the solder paste inspecting machine (120) in order to allow the control device (130) to control the operation of the solder paste printing machine (110) and
to receive inspection data obtained from the solder paste inspecting machine.

**12.** A computer program for optimizing a printing process of a printed circuit board (190), the computer program, when being executed by a data processor, is operative to control and/or to carry out the method as set forth in any one of the claims 1 to 9.
